# EUROPÄISCHE PATENTSCHRIFT

(11) **EP 2 378 302 B1**
(45) Veröffentlichungstag und Bekanntmachung des Hinweises auf die Patenterteilung: **22.08.2012**
(21) Anmeldenummer: 11004437.7
(22) Anmeldetag: 12.06.2008
(51) Int. Cl.: G01R 31/12, G01R 29/08

(54) **Prüfanordnung zur Stossspannungsprüfung von elektrischen Hochspannungskomponenten**
Test assembly for surge voltage testing of high voltage electrical components
Dispositif d'essai pour des composants électriques à haute tension par tension de choc

(43) Veröffentlichungstag der Anmeldung: 19.10.2011
(62) Teilanmeldung aus: 08010755.0
(73) Patentinhaber: ABB Technology AG, 8050 Zürich (CH)
(72) Erfinder: Steiger, Matthias, 06779 Schierau (DE); Werle, Peter Dr.-Ing., 29664 Walsrode (DE)
(74) Vertreter: Partner, Lothar

(56) Entgegenhaltungen:
- DE-A1- 19 639 023
- US-B1- 6 586 697
- HAEFELY HIGH VOLTAGE TEST: "Impulse Voltage Test System SGSA 100-800 kV, 5-40 KJ", 19000101 , 1. Januar 2001 (2001-01-01), XP009109093, Gefunden im Internet: URL:http://web.archive.org/web/20070326174 534/http://www.haefely.com/10-products/10- impulse-voltage-testing.php [gefunden am 2008-11-24]
- M. LOPPACHER: "On-site Impulse Tests and corresponding State of the Art Measurement and Analysis Techniques for Power Transformers", 19000101 , 1. Januar 1999 (1999-01-01), XP009109097, Gefunden im Internet: URL:http://web.archive.org/web/20060316135 407/http://www.haefely.com/pdf/scientific/ e1-95.pdf [gefunden am 2008-11-24]
- WINTER A ET AL: "A mobile transformer test system based on a stativ frequency converter", INTERNET CITATION, 27. August 2007 (2007-08-27), XP002500564,
- SCHUFFT W ET AL: "Frequency-tuned resonant test systems for on-site testing and diagnostics of extruded cables", HIGH VOLTAGE ENGINEERING, 1999. ELEVENTH INTERNATIONAL SYMPOSIUM ON (C ONF. PUBL. NO. 467) LONDON, UK 23-27 AUG. 1999, LONDON, UK,IEE, UK, Bd. 5, 23. August 1999 (1999-08-23), Seiten 335-339, XP006501811, ISBN: 978-0-85296-719-5
- SCHIERIG S ET AL: "HV AC generation based on resonant circuits with variable frequency for testing of electrical power equipment on site", CONDITION MONITORING AND DIAGNOSIS, 2008. CMD 2008. INTERNATIONAL CONFERENCE ON, IEEE, PISCATAWAY, NJ, USA, 21. April 2008 (2008-04-21), Seiten 684-691, XP031292593, ISBN: 978-1-4244-1621-9
- LOPEZ-ROLDAN ET AL: "Mobile Substations: Application, Engineering and Structural Dynamics", PES TD 2005/2006 MAY 21-24, 2006, PISCATAWAY, NJ, USA,IEEE, 1. Januar 2006 (2006-01-01), Seiten 951-956, XP031101946, ISBN: 978-0-7803-9194-9

## Beschreibung

Die Erfindung betrifft eine Prüfanordnung zur Stossspannungsprüfung von elektrischen Hochspannungskomponenten umfassend einen Stossspannungsgenerator und einen Spannungsteiler in Form einer jeweiligen turmähnlichen Struktur mit einem ersten und einem zweiten Strukturende, einen quaderförmigen Behälter mit einem ersten und einem zweiten Behälterende sowie einen Antrieb zur Durchführung einer Schwenkbewegung des Stossspannungsgenerators und/oder des Spannungsteilers zwischen einer ersten jeweils annähernd waagerechten Position in eine zweite jeweils annähernd senkrechte Position um eine jeweilige Drehachse quer zur Längsrichtung des Stossspannungsgenerators.

Es ist allgemein bekannt, dass zur Prüfung von Hochspannungskomponenten, insbesondere von Leistungstransformatoren, Stossspannungsgeneratoren verwendet werden.

Mittels eines Stossspannungsgenerators ist ein Spannungsimpuls erzeugbar, welcher mittels geeigneter elektrischer Verschaltung von Stossspannungsgenerator und Prüfling dem zu testenden Teil des Prüflings, beispielsweise einer Hochspannungswicklung, zugeführt wird. Ein derartiger Spannungsimpuls weist eine zeitliche Dauer im Bereich von üblicherweise bis zu einigen 10µs auf, die maximale Spannung beträgt ― je nach Prüfling ― bis zu einige MV. Aus der kontinuierlichen Messung von Strom und/oder Spannungswerten innerhalb der elektrischen Verschaltung des Testaufbaus bei Einwirken des Spannungsimpulses sind Aufschlüsse über den Zustand der geprüften Komponente ableitbar, beispielsweise auf den Alterungszustand oder auch einen Fehler in der elektrischen lsolation.

Ein Stossspannungsgenerator weist eine Vielzahl von Kondensatoren auf, welche zur Erzeugung eines Hochspannungsimpulses zunächst in elektrischer Parallelschaltung geladen werden und anschließend in elektrischer Reihenschaltung entladen werden. Durch die Reihenschaltung sind entsprechend höhere Spannungen realisierbar. Die Ausführungsform eines Stossspannungsgenerators ist gemäß dem allgemeinen Stand der Technik zumeist in einer turmähnlichen Struktur, in welcher die verwendeten Komponenten Kondensator, Widerstand, Funkenstrecke sowie lsolatoren in einer Gitterstruktur zusammengefügt sind. Die lsolatoren sind auch als Rohre aus einem lsolationsmaterial, beispielsweise GFK, ausführbar, wobei die lsolatoren vorzugsweise längs der turmähnlichen Struktur hintereinander in Form von mehreren sich über die gesamte Länge der Struktur erstreckenden Stützsäulen angeordnet sind und die elektrischen Komponenten quer dazu. Stossspannungsgeneratoren sind in aller Regel nur im senkrechten, aufrechten Zustand zu betreiben, weil nur so alle notwendigen lsolationsabstände zum angrenzenden geerdeten Potential eingehalten sind. Die höchste Spannung tritt an der Spitze des Stossspannungsgenerators auf.

Hochspannungskomponenten wie Leistungstransformatoren weisen ein sehr hohes Gewicht auf, je nach elektrischer Nennleistung auch mehrere 100t. Ein Transport eines derartigen innerhalb eines elektrischen Energieverteilungsnetzes eingebauten Transformators in ein fest installiertes Prüffeld, in welchem im Rahmen einer Stossspannungsprüfung der Transformator im Rahmen einer Wartung oder zu diagnostischen Zwecken geprüft werden könnte, ist aufgrund des hohen Transportaufwandes für den jeweiligen Transformator praktisch ausgeschlossen. Zudem ist in den seltensten Fällen genügend Redundanz in einem Energieverteilungsnetz vorhanden, dass ein Transformator ohne Beeinträchtigung des Netzbetriebes ausgebaut werden könnte.

Aus diesem Grund erfolgen derartige Stossspannungsprüfungen von Leistungstransformatoren zumeist vor Ort. Die Prüfanordnung mit Stossspannungsgenerator sowie weiteren für die Prüfung benötigten Komponenten wie Spannungsteiler, Mess- und Auswertevorrichtungen wird in mehreren Baugruppen zu dem Ort, an dem sich der zu prüfende beziehungsweise zu wartende Transformator befindet, transportiert und dort zu einer Prüfanordnung montiert. lnsbesondere der Spannungsteiler, welcher zur Messung der hohen Spannungen von beispielsweise bis zu 2MV benötigt wird, ist neben dem Stossspannungsgenerator eine Komponente von beachtlicher Größe, beispielsweise einer Höhe von 10m.

Aus den Veröffentlichungen M.Loppacher: "On-site lmpulse Tests and Corresponding State of the Art Measurement and Analysis Techniques for Power Transformers" vom 01.01.1999 und Haefely High Voltage Test: "lmpulse Voltage Test System SGSA 100-800kV, 5-40 kJ" vom 01.01.2001 ist eine Prüfanordnung zur Stossspannungsprüfung von elektrischen Hochspannungskomponenten bekannt geworden, welche für den mobilen Einsatz konzipiert ist und in horizontaler Lage zum Einsatzort transportiert wird, wo sie dann mittels eines hydraulischen Kippmechanismus aufgerichtet wird.

Nachteilig hierbei ist, dass die Montage vor Ort den Einsatz eines Krans erfordert für den Zusammenbau und die Demontage der jeweiligen Komponenten. Insbesondere die Positionierung und Montage eines Stossspannungsgenerators oder eines Spannungsteilers ist sehr zeitaufwändig.

Ausgehend von diesem Stand der Technik ist es Aufgabe der Erfindung, eine Prüfanordnung zur Stossspannungsprüfung von elektrischen Hochspannungskomponenten anzugeben, mit welcher eine Vor-Ort-Montage auf einfache Weise und die Prüfung rasch durchführbar ist.

Diese Aufgabe wird erfindungsgemäß gelöst durch eine Prüfanordnung mit den im Anspruch 1 angegebenen Merkmalen.

Demgemäß kennzeichnet sich die Prüfanordnung der eingangs genannten Art dadurch, dass die erste jeweils annähernd waagerechte Position innerhalb des Behälters befindlich ist und dass in der zweiten annähernd senkrechten Position die isolationstechnischen für eine Hochspannungsprüfung notwendigen Abstände zu geerdeten Komponenten gegeben sind.

Somit ist es möglich, die gesamte Prüfanordnung innerhalb eines einzigen Behälters anzuordnen und zu transportieren. Der Transport erfolgt vorzugsweise in der waagerechten Position von Stossspannungsgenerator und Spannungsteiler, so dass sich alle wesentlichen Komponenten der Prüfanordnung innerhalb der Begrenzung des Behälters befinden.

Die im Betrieb isolationstechnisch notwendigen Abstände von Stossspannungsgenerator und Spannungsteiler zu geerdeten Komponenten, beispielsweise einer Seitenwand des Behälters oder dem angrenzenden Erdreich, ist in dieser waagerechten Position nicht gegeben.

Durch die Schwenkbewegung des Stossspannungsgenerators sowie des Spannungsteilers in eine senkrechte Position sind die isolationstechnisch notwendigen Abstände zu den genannten geerdeten Komponenten gegeben. Eine derartige Schwenkbewegung erfolgt nach Platzierung des Behälters vor Ort in unmittelbarer Nähe zu der zu prüfenden Hochspannungskomponente, beispielsweise in einem Abstand von 5m bis 30m

In vorteilhafter Weise ist so eine komplette Prüfanordnung zur Stossspannungsprüfung transportierbar und mit geringem Aufwand in Betrieb zu nehmen.

ln einer weiteren Ausgestaltung der erfindungsgemäßen Prüfanordnung ist der Behälter mit einer Transportvorrichtung verbunden, welche ihn tragende Räder aufweist, beispielsweise mit einem LKW, einem LKW-Anhänger, einem Sattelschlepper oder einem Eisenbahnwaggon.

Auf diese Weise ist die Prüfanordnung besonders einfach mittels konventioneller Verkehrsmittel transportierbar.

ln einer bevorzugten Ausführungsform der Prüfanordnung weist der Behälter an seinem ersten Ende einen innen liegenden Bereich auf, in welchem Messvorrichtungen und/oder Auswertevorrichtungen angeordnet sind.

Eine Messvorrichtung ist beispielsweise dafür vorgesehen, den Verlauf des Spannungsimpulses während einer Stossspannungsprüfung zu messen und zu erfassen, wobei eine mittels des Spannungsteilers auf ein niedriges Spannungsniveau reduzierte Spannung gemessen wird. Eine Auswertevorrichtung ist dafür vorgesehen, die während des Spannungsimpulses gemessenen und erfassten Werte auszuwerten und beispielsweise eine Aussage über den Zustand der lsolation der geprüften Hochspannungskomponente, beispielsweise einem Leistungstransformator, zu geben.

Alle auch für die Durchführung einer Stossspannungsprüfung benötigten Komponenten sind somit bereits in den Behälter integriert. Der Montageaufwand vor Ort, insbesondere eine Verkabelung der Mess- und Auswertevorrichtungen, ist weiter reduziert.

ln einer weiteren Variante der Prüfanordnung ist der Behälter ein transportierbarer Container, welcher an jeder seiner sechs Seiten zumindest teilweise durch Wände oder Wandsegmente begrenzt ist. Besonders bevorzugt ist die Ausführung des Containers als 40-Fuß Container.

Ein Container mit der Standardabmessung 40-Fuß ist besonders geeignet, mittels üblicher Transportmittel, wie beispielsweise Schiff, Eisenbahn oder LKW transportiert zu werden. Die Länge von 40 Fuß entspricht einer der größten verfügbaren Längen eines Standardcontainers und ist unwesentlich größer als die für die Unterbringung eines Stossspannungsgenerators bzw. Spannungsteilers benötigte Länge von ca. 10m. Prüfanordnungen mit geringeren Längen von Stossspannungsgenerator bzw. Spannungsteiler sind entsprechend auch in kürzeren Containern anordenbar.

ln einer besonders bevorzugten Ausgestaltung der Prüfanordnung ist der Container zugelassen gemäß CSC (Container Safety Convention). Dies bedeutet beispielsweise, dass der Container bei der Verladung auf ein Containerschiff in jeder beliebigen Stapelposition angeordnet werden kann. Der Transport der Prüfanordnung wird dadurch weiter vereinfacht.

In einer weiteren Variante der Prüfanordnung sind der Stossspannungsgenerator und der Behälter an ihren jeweiligen zweiten Enden miteinander mittels einer Drehverbindung verbunden, welche eine besonders einfache Schwenkbewegung von Stossspannungsgenerator und/oder Spannungsteiler von einer waagerechten zu einer senkrechten Position ermöglicht. Vorzugsweise ist ein Antrieb dafür vorgesehen, die Schwenkbewegung durchzuführen.

ln einer weiteren Ausgestaltung der Prüfanordnung ist wenigstens ein während eines Prüfvorgangs notwendiger Verfahrensschritt oder der gesamte Prüfvorgang mittels einer Fernbedienung initiierbar. Die Verwendung einer Fernbedienung reduziert den benötigten Montageaufwand für die Prüfanordnung in vorteilhafter Weise und ermöglicht zudem eine einfachere Durchführung einer Stossspannungsprüfung.

Gemäß einer weiteren Variante der Prüfanordnung ist der Behälter an seiner oberen Seite durch wenigstens eine bewegbare Abdeckung verschließbar. Eine durchgehende Abdeckung schützt die Prüfanordnung beim Transport vor äußeren Einwirkungen wie beispielsweise Regen oder Schmutz und ist zudem bei Ausführung des Behälters als Container mit CSC Zulassung unumgehbar.

Um den Stossspannungsgenerator und den Spannungsteiler erfindungsgemäß von einer waagrechten in eine senkrechte Position schwenken zu können, ist in einer weiteren Ausgestaltung der Prüfanordnung vorgesehen, dass diese durch eine Öffnung an der oberen Seite des Behälters schwenkbar sind, wobei die Öffnung aus einer Bewegung der Abdeckung in eine Endposition resultiert.

Somit ist der Behälter während des Transportes an seiner oberen Seite mit einer durchgehenden Abdeckung verschlossen, welche vor Ort geöffnet wird, so dass ein Aufrichten von Stossspannungsgenerator und Spannungsteiler in eine senkrechte Position ermöglicht ist, welche zum Betrieb des Stossspannungsgenerators aufgrund der Einhaltung von lsolationsabständen notwendig ist.

ln einer weiteren Ausgestaltung der Prüfanordnung ist Behälter an dessen beiden Seitenflächen an seinem zweiten Ende zumindest teilweise jeweils durch wenigstens eine Wand oder ein Wandsegment begrenzt, welches zwischen einer Öffnungsposition und einer Schließposition bewegbar ist. ln der jeweiligen Schließposition sind die Seiten Behälters verschlossen, was sich für dessen Transport als vorteilhaft erweist. ln der jeweiligen Öffnungsposition sind die Seitenwände im hinteren Bereich des Containers an seinem zweiten Ende offen, die jeweilige Wand oder jeweilige Wandsegmente sind also in Richtung des ersten Endes verschoben oder in der Art einer Tür aufgeklappt.

ln der Öffnungsposition sind somit die Bereiche der Seitenwände des Behälters, welche den Betrieb der Prüfanordnung wegen zu geringem lsolationsabstand zum Stossspannungsgenerator behindern würden, aus in einen Bereich mit genügend hohem lsolationsabstand bewegt.

In einer weiteren Ausgestaltung der Prüfanordnung ist der Behälter mittels der jeweils wenigstens einen Wand oder des jeweils wenigstens einen Wandsegmentes in dessen jeweiliger Öffnungsposition gegen ein Kippen gesichert ist.

Dies ist beispielsweise ermöglicht, wenn die hinteren Seitenwände um eine jeweilige senkrechte Achse an der Behälterwand um jeweils 90° in Richtung des vorderen, ersten Endes des Behälters geschwenkt sind. Die Erstreckung des Behälters in der Breite, welche für ein mögliches Kippen maßgeblich ist, ist somit um die jeweiligen Längen der geschwenkten Wände bzw. Wandsegmente erhöht. An den äußeren, drehachsenfernen Enden der Wände bzw. Wandsegmente sind gegebenenfalls Abstützvorrichtungen anzubringen, welche einen eventuellen Abstand zwischen der jeweiligen Unterkante der Wände bzw. Wandsegmente und der Standfläche der Vorrichtung kompensieren. Für den Fall, dass sich die Prüfanordnung auf einer Transportvorrichtung wie einem LKW befindet, ist die daraus resultierende Höhendifferenz des Behälters zur Standfläche durch die Abstützvorrichtungen zu kompensieren.

ln einer weiteren Ausgestaltung der Prüfanordnung ist der Stossspannungsgenerator am zweiten Ende des Behälters mit der betreffenden Stirnwand kraft- und/oder formschlüssig verbunden und zusammen mit dieser um die Drehachse schwenkbar.

Die hintere Stirnwand des Behälters ist aus lsolationsgründen vor dem Betrieb des Stossspannungsgenerators von einer senkrechten Transportposition in eine Position zu bewegen, welche den Betrieb des Stossspannungsgenerators nicht beeinträchtigt. Bei Verbindung mit der Unterseite des Stossspannungsgenerators erfolgt diese Bewegung gleichzeitig mit dem Aufrichten des Stossspannungsgenerators bzw. des Spannungsteilers. Es kann somit ein Arbeitsschritt entfallen.

ln einer besonders bevorzugten Variante der Prüfanordnung sind der Spannungsteiler und der Stossspannungsgenerator mittels einer längenverstellbaren und quer zu deren parallelen Längsachsen wirkenden Bewegungsvorrichtung miteinander verbunden.

Beide Komponenten sind somit platzsparend im waagerechten Zustand in einem geringen parallelen Abstand zueinander transportierbar. Vor Ort sind diese gemeinsam mittels einer einzigen Schwenkbewegung in den senkrechten Zustand überführbar. Der parallele Abstand zwischen Stossspannungsgenerator und Spannungsteiler ist mittels der längenverstellbaren Bewegungsvorrichtung in einfacher Weise auf einen beim Betrieb isolationstechnisch benötigten Abstand erhöhbar.

ln einer weiteren Ausgestaltung der Prüfanordnung ist der Spannungsteiler innerhalb einer Stützsäule des Stossspannungsgenerators integriert ist, welche aus mehreren längs der turmähnlichen Struktur hintereinander angeordneten lsolationsrohren gebildet ist. Der benötigte Platzbedarf ist damit in vorteilhafter Weise reduziert.

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: eine Seitenansicht auf eine Prüfanordnung auf einer Transportvorrichtung mit einem Stossspannungsgenerator in waagerechter Position,
- Fig. 2: eine Seitenansicht auf eine Prüfanordnung auf einer Transportvorrichtung mit einem Stossspannungsgenerator in senkrechter Position sowie

- Fig. 3: eine Draufsicht auf eine Prüfanordnung auf einer Transportvorrichtung mit einem Stossspannungsgenerator in senkrechter Position

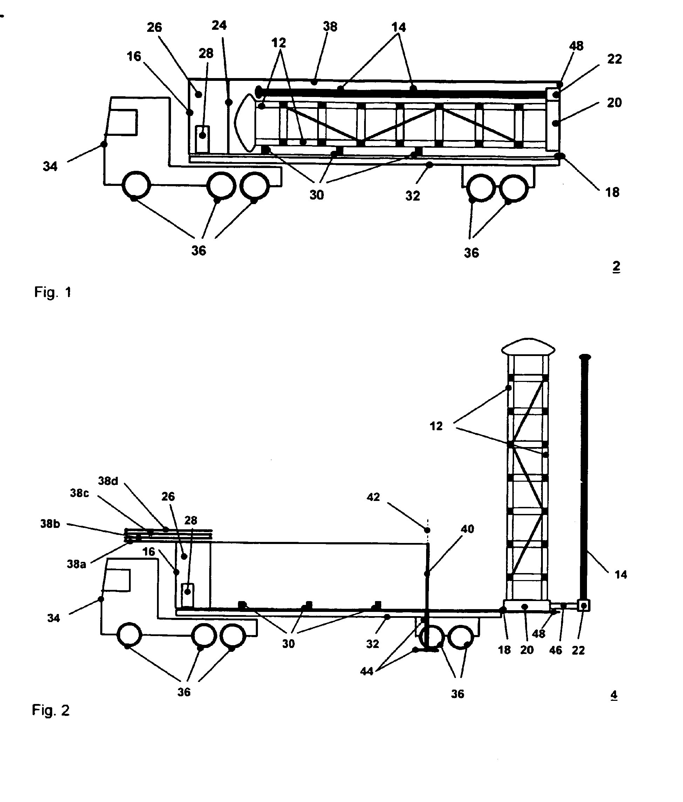

Fig. 1 zeigt eine Seitenansicht 2 auf eine Prüfanordnung auf einer Transportvorrichtung 32, 34, welche auf Rädern 50 bewegbar ist ― einem LKW mit Auflieger. Ein quaderförmiger Behälter 16, welcher mit dem Auflieger 32 verbunden ist, ist in diesem Beispiel als Container ausgeführt. Aus Darstellungsgründen ist eine Seitenwand des Behälters 16 nicht dargestellt, so dass die in ihm befindlichen Komponenten in der Fig. sichtbar sind.

Ein Stossspannungsgenerator 12 ist in waagerechter Position innerhalb des Behälters 16 angeordnet. Am zweiten Ende des Stossspannungsgenerators 12 ist ein erster Sockel 20 mit diesem verbunden, welcher in einer späteren senkrechter Position insbesondere als Standfläche dient. Parallel zur Längsachse des Stossspannungsgenerators ist über diesem ein Spannungsteiler 14 angeordnet. Vorzugsweise grenzen beide Komponenten an einer gemeinsamen Kontaktfläche aneinander an, so dass die Last des Spannungsteilers 14 in waagerechter Position ― gegebenenfalls auch unter Verwendung von Abstandshaltern - von dem Stossspannungsgenerator 12 abgetragen wird, dessen Last wiederum von mehreren Abstandshaltern 30 auf die Fläche des Behälterbodens abgetragen wird.

Der Spannungsteiler 14 ist an seinem zweiten Ende mit einem zweiten Sockel 22 verbunden, der wiederum mittels einer in dieser Darstellung nicht sichtbaren Teleskopschiene mit dem ersten Sockel 20 verbunden ist. Beide Sockel 20, 22 sind zudem mit der hinteren Stirnwand 48 des Behälters 16 verbunden. Stossspannungsgenerator 12, Spannungsteiler 14 und hintere Stirnwand 48 sind um eine gemeinsame Drehachse 18 schwenkbar angeordnet.

lm vorderen Bereich des Behälters 16 ist mittels einer Trennwand 24 ein innen liegender Bereich 26 abgetrennt, innerhalb dessen Mess- und Auswertevorrichtungen 28 untergebracht sind. Dieser Messraum dient vorzugsweise auch als Arbeitsraum für das mit der Stossspannungsprüfung betraute Personal.

Die obere Behälterseite ist mit einer Abdeckung 38 versehen, welche aus mehreren einzelnen Abdeckungssegmenten zusammengesetzt ist und vorzugsweise aus demselben Material gebildet ist wie die Seitenwände des Behälters, beispielsweise Stahl.

Fig. 2 zeigt eine Seitenansicht 4 auf dieselbe Prüfanordnung mit identischen Bezugszeichen wie in Fig. 1. Der Stossspannungsgenerator 12 und der Spannungsteiler 14 sind nunmehr in einer senkrechten Position dargestellt, welche geeignet ist, um eine Stossspannungsprüfung durchzuführen. Eine zu prüfende Komponente, beispielsweise ein Leistungstransformator, sowie zu ihm führende elektrische Verbindungen sind in dieser Fig. nicht dargestellt. Alle elektrischen Verbindungen zwischen am Behälter 16 angeordneten Komponenten 12, 14, 28 sind ebenfalls nicht dargestellt.

Mittels der zwischen erstem Sockel 20 und zweitem Sockel 22 wirkenden Teleskopschiene 46 ist der Abstand zwischen den beiden Sockeln 20, 22, welche in der Fig. 1 aneinandergrenzen, nunmehr vergrößert. Stossspannungsgenerator 12 und Spannungsteiler 14 sind mit ihren parallel verlaufenden Längsachsen soweit voneinander entfernt, dass ein genügend hoher lsolationsabstand für die Durchführung einer Stossspannungsprüfung besteht.

Weiterhin dargestellt ist ein hinteres Wandsegment 40 einer Behälterseite, welches um eine Klappachse 42 senkrecht zur restlichen äußeren Behälterwand bewegt ist. Der hintere Bereich der Behälterseite ist damit frei und es ist ein genügend hoher lsolationsabstand zum aufgerichteten Stossspannungsgenerator 12 erreicht. Am äu-βeren Ende des Wandsegmentes 40 ist eine Stützvorrichtung 44 angebracht, welche das Wandsegment gegenüber der Standfläche des Aufliegers 32 abstützt. Ein derartiges klappbares Wandsegment 40 mit Abstützvorrichtung 44 ist auf beiden Seiten des Behälters 16 vorgesehen. Ein Kippen des Behälters wird dadurch verhindert.

Die in Fig. 1 dargestellte Abdeckung 38 ist nunmehr in Form von mehreren übereinander angeordneten Abdeckungssegmenten 38a, 38b, 38c und 38d im Bereich des vorderen Endes des Behälters 16 befindlich und der Behälter ist an seiner oberen Seite nunmehr geöffnet. Eine entsprechende Öffnungsbewegung beinhaltet sowohl Schiebe- als auch Klappbewegungen der Abdeckungssegmente 38a, 38b, 38c und 38d. Durch diese Öffnung sind Stossspannungsgenerator 12 und Spannungsteiler 14 um die Drehachse 18 schwenkbar.

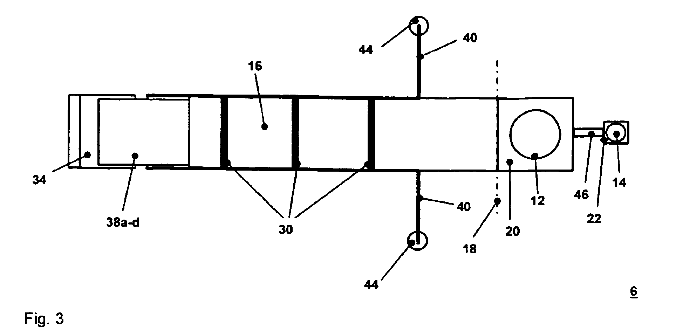

Fig. 3 zeigt die Draufsicht auf dieselbe Anordnung wie in Fig. 2 dargestellt mit denselben Bezugszeichen. Besonders gut sichtbar ist in dieser Darstellung die Abstützfunktion der aufgeklappten Wandsegmente 40 mit Abstützvorrichtung 44.

### Bezugszeichenliste

- 2: Seitenansicht auf eine Prüfanordnung auf einer Transportvorrichtung mit einem Stossspannungsgenerator in waagerechter Position
- 4: Seitenansicht auf eine Prüfanordnung auf einer Transportvorrichtung mit einem Stossspannungsgenerator in senkrechter Position
- 6: Draufsicht auf eine Prüfanordnung auf einer Transportvorrichtung mit einem Stossspannungsgenerator in senkrechter Position
- 12: Stossspannungsgenerator
- 14: Spannungsteiler
- 16: Quaderförmiger Behälter
- 18: Drehachse
- 20: Erster Sockel
- 22: Zweiter Sockel
- 24: Trennwand
- 26: lnnen liegender Bereich
- 28: Messvorrichtung / Auswertevorrichtung
- 30: Abstandshalter
- 32: Erste Transportvorrichtung
- 34: Zweite Transportvorrichtung
- 36: Rad
- 38: Abdeckung der oberen Behälterseite
- 38a: Erstes Abdeckungssegment
- 38b: Zweites Abdeckungssegment
- 38c: Drittes Abdeckungssegment
- 38d: Viertes Abdeckungssegment
- 40: Wandsegment von Behälterseite
- 42: Klappachse
- 44: Stützvorrichtung
- 46: Teleskopschiene
- 48: Stirnwand am zweiten Ende des Behälters

## Patentansprüche

1. Prüfanordnung (2, 4, 6) zur Stossspannungsprüfung von elektrischen Hochspannungskomponenten, umfassend
- einen Stossspannungsgenerator (12) und einen Spannungsteiler (14) in Form einer jeweiligen turmähnlichen Struktur mit einem ersten und einem zweiten Strukturende,
- einen quaderförmigen Behälter mit einem ersten und einem zweiten Behälterende,
- *eine Drehverbindung mittels welcher der Stossspannungsgenerator* (12) *und der Behälter (16) an ihren jeweiligen zweiten Enden quer zur Längsrichtung des Stossspannungsgenerators (12) miteinander verbunden sind,*
- einen Antrieb, der zur Durchführung einer Schwenkbewegung des Stossspannungsgenerators (12) und/oder des Spannungsteilers (14) zwischen einer ersten jeweils annähernd waagerechten Position in eine zweite jeweils annähernd senkrechte Position um die Drehachse (18) der Drehverbindung angepasst ist,
**dadurch gekennzeichnet,**
**dass** die erste jeweils annähernd waagerechte Position innerhalb des Behälters befindlich ist und dass in der zweiten annähernd senkrechten Position die isolationstechnischen für eine Hochspannungsprüfung notwendigen Abstände zu geerdeten Komponenten gewährleistet sind.

2. Prüfanordnung nach Anspruch 1, **dadurch gekennzeichnet, dass** der Behälter (16) mit einer Transportvorrichtung (32, 34) verbunden ist, welche ihn tragende Räder (50) aufweist.

3. Prüfanordnung nach Anspruch 1 oder 2, **dadurch gekennzeichnet, dass** der Behälter (16) an seinem ersten Ende einen innen liegenden Bereich (26) aufweist, in welchem Messvorrichtungen (28) und/oder Auswertevorrichtungen (28) angeordnet sind.

4. Prüfanordnung nach einem der vorherigen Ansprüche, **dadurch gekennzeichnet dass** der Behälter (16) ein transportierbarer Container ist, welcher an jeder seiner sechs Seiten zumindest teilweise durch Wände (38, 48) oder Wandsegmente (38a, 38b, 38c, 38d, 40) begrenzt ist.

5. Prüfanordnung nach Anspruch 4, **dadurch gekennzeichnet, dass** der Container als 40-Fuß Container ausgeführt ist.

6. Prüfanordnung nach Anspruch 4 oder 5, **dadurch gekennzeichnet, dass** der Container gemäß Container Safety Convention (CSC) zugelassen ist.

7. Prüfanordnung nach einem der vorangegangenen Ansprüche, **dadurch gekennzeichnet, dass** wenigstens ein während eines Prüfvorgangs notwendiger Verfahrensschritt oder der gesamte Prüfvorgang mittels einer Fernbedienung initiierbar ist.

8. Prüfanordnung nach einem der vorherigen Ansprüche, **dadurch gekennzeichnet, dass** der Behälter (16) an seiner oberen Seite durch wenigstens eine bewegbare Abdeckung (38, 38a, 38b, 38c, 38d) verschließbar ist.

9. Prüfanordnung nach Anspruch 8, **dadurch gekennzeichnet, dass** der Stossspannungsgenerator (12) und der Spannungsteiler (14) durch eine Öffnung an der oberen Seite des Behälters (16) schwenkbar sind, welche Öffnung aus der Bewegung der Abdeckung (38, 38a, 38b, 38c, 38d) in eine Endposition resultiert.

10. Prüfanordnung nach einem der vorherigen Ansprüche, **dadurch gekennzeichnet, dass** der Behälter (16) an dessen beiden Seitenflächen an seinem zweiten Ende zumindest teilweise jeweils durch wenigstens eine Wand oder ein Wandsegment (40) begrenzt ist, welches zwischen einer Öffnungsposition und einer Schließposition bewegbar.

11. Prüfanordnung nach einem Anspruch 10, **dadurch gekennzeichnet, dass** der Behälter mittels der jeweils wenigstens einen Wand oder des jeweils wenigstens einen Wandsegmentes (40) in dessen jeweiliger Öffnungsposition gegen ein Kippen gesichert ist.

12. Prüfanordnung nach einem der vorherigen Ansprüche, **dadurch gekennzeichnet, dass** der Stossspannungsgenerator am zweiten Ende des Behälters mit der betreffenden Stirnwand (48) kraft- und/oder formschlüssig verbunden ist und zusammen mit dieser um die Drehachse (18) schwenkbar ist.

13. Prüfanordnung nach einem der vorherigen Ansprüche, **dadurch gekennzeichnet, dass** der Spannungsteiler und der Stossspannungsgenerator mittels einer längenverstellbaren und quer zu deren parallelen Längsachsen wirkenden Bewegungsvorrichtung miteinander verbunden sind.

14. Prüfanordnung nach einem der vorherigen Ansprüche, **dadurch gekennzeichnet, dass** der Spannungsteiler innerhalb einer Stützsäule des Stossspannungsgenerators integriert ist, welche aus mehreren längs der turmähnlichen Struktur hintereinander angeordneten Isolationsrohren gebildet ist.

## Claims

1. Test arrangement (2, 4, 6) for impulse voltage testing of high-voltage electrical components, comprising
- an impulse voltage generator (12) and a voltage divider (14) in the form of a respective tower-like structure having a first and a second structure end,
- a rectangular box having a first and a second box end,
- a rotary joint by means of which the impulse voltage generator (12) and the box (16) are connected to one another at their respective second ends transversely relative to the longitudinal direction of the impulse voltage generator (12),
- a drive which is suitable for executing a swivel movement of the impulse voltage generator (12) and/or of the voltage divider (14) about the rotational axis (18) of the rotary joint between a first, in each case approximately horizontal position into a second, in each case approximately vertical position,
**characterized**
**in that** the first, in each case approximately horizontal position is situated within the box, and in that, in the second, approximately vertical position, the distances from earthed components, which distances are necessary in respect of insulation technics for a high-voltage test, are ensured.

2. Test arrangement according to Claim 1, **characterized in that** the box (16) is connected to a transport device (32, 34) having wheels (36) that carry the box.

3. Test arrangement according to Claim 1 or 2, **characterized in that** the box (16) has, at its first end, an inner region (26) in which measurement devices (28) and/or evaluation devices (28) are arranged.

4. Test arrangement according to any one of the preceding claims, **characterized in that** the box (16) is a transportable container that is delimited on each of its six sides, at least partially, by walls (38, 48) or wall segments (38a, 38b, 38c, 38d, 40).

5. Test arrangement according to Claim 4, **characterized in that** the container is realized as a 40-foot container.

6. Test arrangement according to Claim 4 or 5, **characterized in that** the container is approved in accordance with Container Safety Convention (CSC).

7. Test arrangement according to any one of the preceding claims, **characterized in that** at least one process step that is necessary during a test operation, or the entire test operation, can be initiated by means of a remote control.

8. Test arrangement according to any one of the preceding claims, **characterized in that** the box (16) is closable, on its upper side, by at least one movable cover (38, 38a, 38b, 38c, 38d).

9. Test arrangement according to Claim 8, **characterized in that** the impulse voltage generator (12) and the voltage divider (14) can be swivelled through an opening in the upper side of the box (16), which opening results from the movement of the cover (38, 38a, 38b, 38c, 38d) into an end position.

10. Test arrangement according to any one of the preceding claims, **characterized in that** the box (16) is delimited, at its two side faces at its second end, at least partially in each case, by at least one wall or one wall segment (40) that is movable between an open position and a closed position.

11. Test arrangement according to Claim 10, **characterized in that** the box is secured against tilting, by means of the respectively at least one wall or the respectively at least one wall segment (40), in its respective open position.

12. Test arrangement according to any one of the preceding claims, **characterized in that** the impulse voltage generator is non-positively and/or positively connected, at the second end of the box, to the respective end wall (48), and can be swivelled, together with the latter, about the rotational axis (18).

13. Test arrangement according to any one of the preceding claims, **characterized in that** the voltage divider and the impulse voltage generator are connected to one another by means of a longitudinally adjustable motion device that acts transversely relative to their parallel longitudinal axes.

14. Test arrangement according to any one of the preceding claims, **characterized in that** the voltage divider is integrated within a support column of the impulse voltage generator, which support column is constituted by a plurality of insulation tubes arranged in succession along the tower-like structure.

## Revendications

1. Arrangement d'essai (2, 4, 6) pour un essai de tension de choc de composants électriques haute tension, comprenant
- un générateur de tension de choc (12) et un diviseur de tension (14) sous la forme d'une structure respective similaire à une tour munie d'une première et d'une deuxième extrémité de structure,
- un récipient de forme parallélépipédique muni d'une première et d'une deuxième extrémité de récipient,
- une liaison rotative au moyen de laquelle le générateur de tension de choc (12) et le récipient (16) sont reliés entre eux à leurs deuxièmes extrémités respectives, transversalement par rapport au sens longitudinal du générateur de tension de choc (12),
- un mécanisme d'entraînement qui est adapté pour effectuer un mouvement de pivotement du générateur de tension de choc (12) et/ou du diviseur de tension (14) entre une première position respective approximativement horizontale et une deuxième position respective approximativement verticale autour de l'axe de rotation (18) de la liaison rotative,
**caractérisé en ce**
**que** la première position respective approximativement horizontale se trouve à l'intérieur du récipient et en ce que dans la deuxième position approximativement verticale, les écarts de technique d'isolation par rapport aux composants reliés à la terre, nécessaires pour un essai de haute tension, sont garantis.

2. Arrangement d'essai selon la revendication 1, **caractérisé en ce que** le récipient (16) est relié avec un dispositif de transport (32, 34) qui présente des roues (36) qui le portent.

3. Arrangement d'essai selon la revendication 1 ou 2, **caractérisé en ce que** le récipient (16) présente à sa première extrémité une zone intérieure (26) dans laquelle sont disposés des dispositifs de mesure (28) et/ou des dispositifs d'interprétation (28).

4. Arrangement d'essai selon l'une des revendications précédentes, **caractérisé en ce que** le récipient (16) est un conteneur transportable qui est délimité au moins partiellement à chacun de ses six côtés par des parois (38, 48) ou des segments de paroi (38a, 38b, 38c, 38d, 40).

5. Arrangement d'essai selon la revendication 4, **caractérisé en ce que** le conteneur est un conteneur de 40 pieds.

6. Arrangement d'essai selon la revendication 4 ou 5, **caractérisé en ce que** le conteneur est homologué conformément à la Convention internationale sur la sécurité des conteneurs (CSC).

7. Arrangement d'essai selon l'une des revendications précédentes, **caractérisé en ce qu'**au moins une étape du procédé nécessaire pendant une opération d'essai ou l'opération d'essai entière peut être initiée au moyen d'une commande à distance.

8. Arrangement d'essai selon l'une des revendications précédentes, **caractérisé en ce que** le récipient (16) peut être fermé sur son côté supérieur par au moins un couvercle (38, 38a, 38b, 38c, 38d) mobile.

9. Arrangement d'essai selon la revendication 8, **caractérisé en ce que** le générateur de tension de choc (12) et le diviseur de tension (14) peuvent pivoter à travers une ouverture sur le côté supérieur du récipient (16), laquelle ouverture résulte du déplacement du couvercle (38, 38a, 38b, 38c, 38d) dans une position finale.

10. Arrangement d'essai selon l'une des revendications précédentes, **caractérisé en ce que** le récipient (16) est délimité sur ses deux parois latérales, au niveau de sa deuxième extrémité, au moins partiellement à chaque fois par au moins une paroi ou un segment de paroi (40), lequel peut être déplacé entre une position d'ouverture et une position de fermeture.

11. Arrangement d'essai selon la revendication 10, **caractérisé en ce que** le récipient est sécurisé contre un basculement au moyen de l'au moins une paroi respective ou de l'au moins un segment de paroi respectif (40) dans sa position d'ouverture respective.

12. Arrangement d'essai selon l'une des revendications précédentes, **caractérisé en ce que** le générateur de tension de choc est relié par adhérence et/ou par complémentarité de forme au niveau de la deuxième extrémité du récipient avec la paroi frontale (48) concernée et peut pivoter conjointement avec celle-ci autour de l'axe de rotation (18).

13. Arrangement d'essai selon l'une des revendications précédentes, **caractérisé en ce que** le diviseur de tension et le générateur de tension de choc sont reliés entre eux au moyen d'un dispositif de déplacement réglable en longueur et agissant transversalement par rapport à leurs axes longitudinaux parallèles.

14. Arrangement d'essai selon l'une des revendications précédentes, **caractérisé en ce que** le diviseur de tension est intégré à l'intérieur d'une colonne de soutien du générateur de tension de choc, laquelle est formée de plusieurs tubes isolants disposés les uns derrière les autres le long de la structure similaire à une tour.
